# EUROPÄISCHE PATENTSCHRIFT

(11) **EP 1 973 014 B1**
(45) Veröffentlichungstag und Bekanntmachung des Hinweises auf die Patenterteilung: **28.09.2011**
(21) Anmeldenummer: 07005591.8
(22) Anmeldetag: 19.03.2007
(51) Int. Cl.: G05B 9/02

(54) **Einrichtung und Verfahren zur automatischen Erkennung und Unterscheidung von an eine zweikanalige Sicherheitskombination angeschlossenen ein- oder zweikanaligen elektronischen Sensoren**
Device and method for automatic recognition and differentiation of one or two channel electronic sensors connected to a two channel safety combination
Dispositif et procédé destinés à la reconnaissance et la différentiation automatiques de capteurs électrique à un ou deux canaux raccordés à une combinaison de sécurité à deux canaux

(43) Veröffentlichungstag der Anmeldung: 24.09.2008
(73) Patentinhaber: SIEMENS AKTIENGESELLSCHAFT, 80333 München (DE)
(72) Erfinder: Schäfer, Manfred, 91207 Lauf (DE)

(56) Entgegenhaltungen:
- US-A1- 2003 011 250
- US-A1- 2005 057 868

## Beschreibung

Sicherheitskombinationen werden in Bereichen eingesetzt, in denen im Falle einer Störung oder eines Defekts erheblicher Schaden für Menschen und Umwelt ausgehen kann, beispielsweise in Atomkraftwerken. Eine Sicherheitskombination dient dazu, eine Not-Aus-Einrichtung, wie etwa einen Not-Aus-Taster oder einen einen Not-Aus initiierenden elektronischen Sensor mit einer Not-Abschaltungseinrichtung zu verbinden, wobei die Funktionsfähigkeit der Not-Aus-Einrichtung sowie der Verbindungsleitungen zwischen Not-Aus-Einrichtung und Sicherheitseinrichtung permanent überwacht wird.

Dies erfolgt durch einen permanenten oder gepulsten Niederspannungs-Stromfluss über die Verbindungsleitungen zwischen Sicherheitskombination und Not-Aus-Einrichtung. Da es vorkommen kann, dass eine als Not-Aus-Taster ausgeführte Not-Aus-Einrichtung mechanisch blockiert ist und dadurch nicht betätigt werden kann, ist es üblich, so genannte zweikanalige Sicherheitskombinationen zu verwenden, an die parallel zueinander zwei in unmittelbarer Nähe zueinander platzierte Not-Aus-Taster, die über einen gemeinsamen Schaltknopf betätigt werden, angeschlossen sind. Üblicherweise verlaufen bei zweikanaligen Sicherheitskombinationen die auch als Kanäle bezeichneten Verbindungsleitungspaare aus Hin- und Rückleitung zu den beiden Not-Aus-Tastern parallel zueinander. Hierdurch besteht die Gefahr eines so genannten Querschlusses, bei dem die Stromführenden Verbindungsleitungen miteinander verbunden werden. Hierdurch könnte die Sicherheitskombination nicht mehr feststellen, ob ein Not-Aus-Taster betätigt wurde, oder nicht.

Als Gegenmaßnahme wird eine so genannte Querschlusserkennung verwendet, mit der ein Stromfluss zwischen den beiden Kanälen erkannt werden kann. Dies erfolgt, indem der Stromfluss durch die beiden parallel angeordneten Not-Aus-Taster abwechselnd nacheinander gepulst wird. Wird an einem mit einem ersten Not-Aus-Taster verbundenen Eingang der Sicherheitskombination ein Stromfluss zu einem Zeitpunkt festgestellt, bei dem ein Strompuls auf einen mit dem zweiten Not-Aus-Taster verbundenen Ausgang der Sicherheitskombination gegeben wird, ist dies ein Hinweis auf einen Querschluss.

Ein Unterschied bei der Verwendung elektronischer Sensoren anstelle von Not-Aus-Tastern ist, dass die Funktion des Sensors bzw. dessen Ausgänge regelmäßig überprüft wird, was durch eine Selbstüberwachung des elektronischen Sensors durchgeführt wird. Hierzu sendet der elektronische Sensor ein Niederspannungs-Signal, das er kurzzeitig in regelmäßigen Abständen abschaltet. Gleichzeitig wird sensorintern überprüft, ab am Ausgang die Niederspannung abgeschaltet worden ist, oder nicht. Ist die Niederspannung abgeschaltet, wird das Signal wieder auf den Ausgang gelegt. Das kurzzeitige Abschalten, das Überprüfen und das Wiederanschalten erfolgt so schnell, dass es für die Sicherheitskombination nicht erkennbar ist.

Aus wirtschaftlichen Gesichtspunkten ist es bei der Herstellung von Sicherheitskombinationen nicht sinnvoll, zwischen ein- und zweikanaligen Sicherheitskombinationen für Not-Aus initiierende elektronische Sensoren und Not-Aus-Taster zu unterscheiden. Außerdem kommt es häufig vor, dass bereits installierte Sicherheitskombinationen von Not-Aus-Tastern auf elektronische Sensoren, oder umgekehrt umgestellt werden, da sich die Anforderungen im Laufe der Zeit ändern.

Deshalb werden Sicherheitskombinationen hauptsächlich zweikanalig ausgeführt. Diese zweikanaligen Sicherheitskombinationen verfügen über eine interne Umschaltung zwischen ein- und zweikanaligem Betrieb. Bei einkanaligem Betrieb kann ein elektronischer Sensor oder ein Not-Aus-Taster angeschlossen werden. Bei zweikanaligem Betrieb führt die Sicherheitskombination eine Querschlusserkennung durch gepulste Stromflüsse durch. Darüber hinaus sind in der Sicherheitskombination umsteckbare Brücken angeordnet, mit denen im einkanaligen Betrieb die beiden Kanäle elektrisch miteinander verbunden werden müssen.

Soll an eine derart ausgestattete zweikanalige Sicherheitskombination ein zweikanaliger elektronischer Sensor angeschlossen werden, muss ebenso wie bei zwei parallel angeschlossenen Not-Aus-Tastern eine Querschlusserkennung durchgeführt werden. Während bei Not-Aus-Tastern die Sicherheitskombination die Querschlussüberwachung bis zu den Not-Aus-Tastern übernimmt, übernehmen an die Sicherheitskombination angeschlossene elektronische Sensoren die Querschlussüberwachung bis zu den Anschlussklemmen der Sicherheitskombination selbst, da sich zweikanalige Sensoren ebenso wie einkanalige Sensoren ohnehin selbst überwachen müssen. Um dies zu ermöglichen, muss die Sicherheitskombination in einkanaligen Betrieb geschaltet werden, wodurch die Querschlusserkennung der Sicherheitskombination deaktiviert ist, und durch Entfernen bzw. Umstecken mindestens einer Brücke die elektrische Verbindung zwischen den beiden Kanälen unterbrochen werden.

Diese Vorgehensweise ist fehleranfällig, zeitaufwändig und damit kostspielig und stellt eine potentielle Fehlerquelle und damit ein Sicherheitsrisiko dar. US 2003/0011250 offenbart eine Einrichtung welche an eine zweikanalige Sicherheitskombination angeschlossen ist.

Eine Aufgabe der Erfindung ist es, eine Einrichtung und ein Verfahren zur automatischen Erkennung und Unterscheidung von an eine Sicherheitskombination angeschlossenen ein- oder zweikanaligen elektronischen Sensoren zu entwickeln.

Die Aufgabe wird gelöst durch die Merkmale des Anspruchs 1 bzw. durch die Merkmale des Anspruchs 6.

Ein erster Gegenstand der Erfindung betrifft demnach eine Einrichtung zur automatischen Erkennung und Unterscheidung mindestens von an eine zwei Verbindungsleitungspaare für Not-Aus-Einrichtungen in Form von elektronischen Sensoren oder Not-Aus-Tastern aufweisende, zweikanalige Sicherheitskombination angeschlossenen ein- oder zweikanaligen elektronischen Sensoren, bei der ein erstes Verbindungsleiterpaar für einen einkanaligen Betrieb, und das erste und ein zweites Verbindungsleitungspaar für einen zweikanaligen Betrieb der Sicherheitskombination vorgesehen sind. Erfindungsgemäß umfasst die Einrichtung einen mindestens in einer ersten Verbindungsleitung des zweiten Verbindungsleitungspaares angeordneten Ohmschen Widerstand, sowie einen mit seinem Emitter oder mit seinem Kollektor mit einer ersten Seite des Ohmschen Widerstandes, und mit seiner Basis mit einer zweiten Seite des Ohmschen Widerstandes verbundenen Transistor. Der Transistor ist derart beidseitig mit dem Ohmschen Widerstand verbunden, dass während eines Stromflusses des Niederspannungssignals durch einen an die beiden Verbindungsleiterpaare angeschlossenen zweikanaligen elektronischen Sensor eine an dem ohmschen Widerstand abfallende Spannung den Transistor schaltet, so dass am Kollektor oder am Emitter des Transistors eine Ausgangssignal erzeugt wird, welches einen Anschluss des zweikanaligen elektronischen Sensors anzeigt.

Der Begriff schalten beschreibt hier eine Zustandsänderung des Transistors. Es ist demnach im Rahmen der Erfindung sowohl denkbar, dass bei einem mit seinem Emitter mit der ersten Seite des Ohmschen Widerstandes und mit seiner Basis mit der zweiten Seite des Ohmschen Widerstandes verbundenen Transistor bei angeschlossenem zweikanaligem elektronischen Sensor an dessen Kollektor eine Spannung anliegt bzw. Strom fließt, als auch, dass eine Spannung oder ein fließender Strom abgeschaltet werden. Der Begriff Transistor umfasst jegliche Art von elektronischen oder elektromechanischen Schaltern, die bei Anlegen einer Spannung bestimmter Polarität an einem Ausgang eine Strom- oder Spannungsänderung erzeugen. Ein nicht unwesentliches Element der Erfindung ist es, dass der Transistor vorzugsweise nur dann geschaltet wird, wenn durch den zweikanaligen elektronischen Sensor ein Strom von dem Sensor zu der Sicherheitskombination fließt. Somit wird erfindungsgemäß die Richtung des Stromflusses durch den Ohmschen Widerstand berücksichtigt.

Durch die Erfindung erzielbare Vorteile ergeben sich dadurch, dass ein Ausgangssignal zur Verfügung gestellt wird, welches beispielsweise zum Betätigen eines Schalters verwendet werden kann, der je nachdem, ob ein zweikanaliger elektronischer Sensor an die Sicherheitskombination angeschlossen ist, oder nicht, die beiden Verbindungsleiterpaare elektrisch trennt, oder verbunden lässt. Außerdem stellt die spezielle Ausgestaltung mittels eines Ohmschen Widerstandes sicher, dass die Einrichtung aus Sicht des elektronischen Sensors, sowie aus Sicht der Sicherheitskombination bei der Querschlusserkennung transparent ist, d.h. dass aus beiden Richtungen betrachtet auch hinter dem Ohmschen Widerstand auftretende Querschlüsse erkannt werden können. Bei einer Verwendung von Dioden wäre dies nicht möglich, zumindest nicht bei einer Sicherheitskombination, die zwischen zwei Betriebsmodi, einem für den Einkanal-Betrieb sowie für den Anschluss eines zweikanaligen elektronischen Sensors, und einem für den Zweikanal-Betrieb mit zwei parallel angeschlossenen Not-Aus-Tastern vorgesehen ist, bei dem die Sicherheitskombination die Querschlussprüfung übernimmt. Selbstverständlich kann der Ohmsche Widerstand auch durch den spezifischen Widerstand des für die Verbindungsleitungen verwendeten Materials gebildet werden.

Eine vorteilhafte Ausgestaltung der erfindungsgemäßen Einrichtung sieht vor, dass die Einrichtung einen die ersten und/oder die zweiten Verbindungsleitungen der beiden Verbindungsleiterpaare elektrisch miteinander verbindenden oder trennenden, mittels des Ausgangssignals derart schaltbaren Schalter umfasst, dass bei einem angeschlossenen, zweikanaligen elektronischen Sensor eine ansonsten bestehende elektrische Verbindung zwischen den beiden Verbindungsleiterpaaren getrennt ist. Eine Schaltbarkeit mittels des Ausgangssignals umfasst selbstverständlich auch die Verstärkung und/oder Invertierung des Ausgangssignals, sowie alle denkbaren Möglichkeiten, mittels des Ausgangssignals direkt oder indirekt einen Schalter zu steuern.

Vorteile hieraus ergeben sich dadurch, dass an eine zweikanalige Sicherheitskombination wahlweise eine ein- oder zweikanalige Not-Aus-Einrichtung angeschlossen werden kann, ohne dass intern in der Sicherheitskombination durch Setzen oder Entfernen von Brücken irgendwelche Verbindungen zwischen den Kanälen hergestellt, unterbrochen oder verändert werden müssen. Dies wird dadurch erreicht, dass das den zweiten Kanal bildende Verbindungsleitungspaar überwacht und beim Erkennen eines Niederspannungssignals eines zweikanaligen elektronischen Sensors die interne Brücke zwischen den beiden Kanälen durch Betätigen des Schalters automatisch unterbrochen wird. Diese Erkennung hat keinen Einfluss auf den elektronische Sensor, wodurch die Querschlusserkennung des elektronischen Sensors bis zu den Anschlussklemmen der Sicherheitskombination bestehen bleibt.

Somit muss sich weder ein Betreiber, noch ein Hersteller oder Monteur einer Sicherheitskombination sich darum kümmern, ob er einen Not-Aus-Taster oder einen elektronischen Sensor an die Sicherheitskombination anschließt. Die erfindungsgemäße Einrichtung erkennt automatisch, um welche Art Not-Aus-Einrichtung es sich handelt und schließt oder öffnet den bei Bedarf eine elektrische Verbindung zwischen den beiden Kanälen herstellenden Schalter selbständig. Hierdurch werden Fehleinstellungen und damit potentielle Sicherheitsrisiken vermieden.

Vorzugsweise ist der Schalter in der Sicherheitskombination angeordnet. Hierdurch werden Beschädigungen vermieden und Sicherheitsrisiken ausgeschlossen.

Gemäß einer vorteilhaften Ausgestaltung der erfindungsgemäßen Einrichtung weist die Sicherheitskombination zwei umschaltbare Betriebsmodi auf, einen Einkanal-Betriebsmodus zum Anschluss eines einkanaligen Not-Aus-Tasters oder eines ein- oder zweikanaligen elektronischen Sensors, sowie einen Zweikanal-Betriebsmodus zum parallelen Anschluss eines zweikanaligen Not-Aus-Tasters.

Dabei kann der Schalter zusätzlich mittels eines zweiten, von der Sicherheitskombination in einem einkanaligen Betriebsmodus ausgegebenen Schaltsignals für den Fall des Anschlusses eines zweikanaligen Not-Aus-Taster schaltbar sein.

Ein zweiter Gegenstand der Erfindung betrifft ein Verfahren zur automatischen Erkennung und Unterscheidung mindestens von an eine zwei Verbindungsleitungspaare zum Anschluss von Not-Aus-Einrichtungen in Form von elektronischen Sensoren oder Not-Aus-Tastern aufweisende, zweikanalige Sicherheitskombination angeschlossenen ein- oder zweikanaligen elektronischen Sensoren, wobei ein erstes Verbindungsleiterpaar für einen einkanaligen Betrieb, und das erste und ein zweites Verbindungsleitungspaar für einen zweikanaligen Betrieb der Sicherheitskombination vorgesehen sind. Das erfindungsgemäße Verfahren sieht vor, dass entlang mindestens einer Verbindungsleitung des zweiten Verbindungsleitungspaares während eines Stromflusses durch einen an die beiden Verbindungsleiterpaare angeschlossenen zweikanaligen elektronischen Sensor ein elektrischer Spannungsabfall gemessen wird, dessen Polarität eine Anzeige für einen angeschlossenen zweikanaligen elektronischen Sensor ist.

Das erfindungsgemäße Verfahren erlaubt durch das elektrische Potential zwischen beispielsweise zwei Enden eines Ohmschen Widerstandes und durch die Polarität zwischen den Potentialen sowohl einen zweikanaligen Betriebsmodus zu erkennen, als auch angeschlossene zweikanalige elektronische Sensoren zu erkennen. Das Verfahren kann dazu verwendet werden, Sicherheitskombinationen völlig automatisch in Abhängigkeit von den angeschlossenen Not-Aus-Einrichtungen zu konfigurieren. So ist beispielsweise denkbar, das das erfindungsgemäße Verfahren dazu verwendet wird, zunächst anhand eines elektrischen Potentials zwischen den beiden Enden des Ohmschen Widerstandes einen zweikanaligen Betrieb zu erkennen, und anschließend anhand der Polarität der Spannung zwischen den beiden Potentialen rückzuschließen, ob zwei Not-Aus-Taster parallel an die beiden die Kanäle bildenden Verbindungsleiterpaare angeschlossen sind, oder ob es sich um einen zweikanaligen elektronischen Sensor handelt. Hierdurch ist sowohl eine automatische Herstellung oder Trennung elektrischer Verbindungen zwischen den Kanälen möglich, als auch ein automatisches Umschalten zwischen den Betriebsmodi der Sicherheitskombination denkbar.

Eine vorteilhafte Ausgestaltung der Erfindung sieht deshalb vor, dass der beispielsweise an einem in einer Versorgungsleitung eines Versorgungsleitungspaares zum Anschluss zweikanaliger Not-Aus-Einrichtungen angeordneten Ohmschen Widerstand auftretende Spannungsabfall verwendet wird, um eine ansonsten bestehende elektrische Verbindung zwischen den beiden Verbindungsleitungspaaren bei angeschlossenem zweikanaligen elektronischem Sensor zu trennen.

Die Erfindung wird nachfolgend anhand eines Ausführungsbeispiels näher beschrieben. Es zeigen
- FIG 1: eine schematische Darstellung der Anordnung einer erfindungsgemäßen Einrichtung, sowie
- FIG 2: eine schematische Darstellung der zur Erzeugung eines Ausgangssignals verwendeten Teile der Einrichtung aus FIG 1 im Detail.

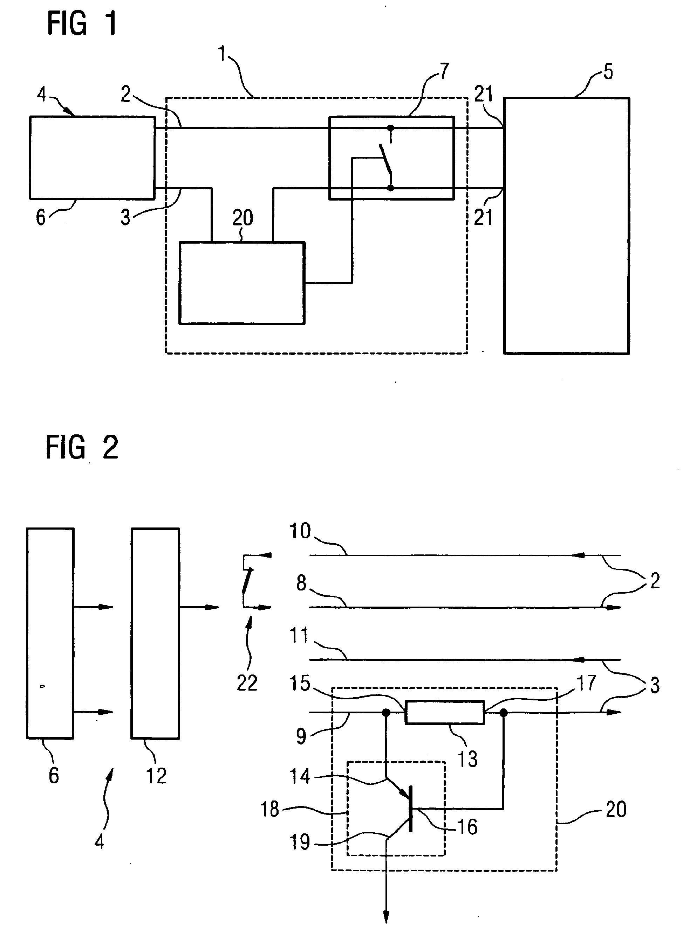

In FIG 1 ist eine Einrichtung 1 zur automatischen Erkennung und Unterscheidung von zweikanaligen elektronischen Sensoren 6 dargestellt, welche an eine zweikanalige Sicherheitskombination 5 mit zwei Verbindungsleitungspaaren 2, 3 für Not-Aus-Einrichtungen 4 angeschlossen sind. Die Not-Aus-Einrichtungen 4 sind in Form von zweikanaligen elektronischen Sensoren 12, einkanaligen elektronischen Sensoren 6 oder einkanaligen Not-Aus-Tastern 22 vorgesehen, vgl. FIG 2. Dabei ist ein erstes Verbindungsleiterpaar 2 für einen einkanaligen Betrieb (Kanal 1), und das erste 2 und ein zweites Verbindungsleitungspaar 3 für einen zweikanaligen Betrieb (Kanäle 1 und 2) der Sicherheitskombination 5 vorgesehen. Die Einrichtung 1 umfasst im Wesentlichen eine Signalerkennungseinrichtung 20, sowie einen mittels eines Ausgangssignals der Signalerkennungseinrichtung 20 schaltbaren Schalter 7.

Der mittels des Ausgangssignals der Signalerkennungseinrichtung 20 schaltbare Schalter 7 dient dabei dazu, die ersten 8, 9 und/oder die zweiten Verbindungsleitungen 10, 11 (FIG 2) der beiden Verbindungsleiterpaare 2, 3 derart elektrisch miteinander zu verbinden oder zu trennen, dass bei einem angeschlossenen, zweikanaligen elektronischen Sensor eine ansonsten bestehende elektrische Verbindung zwischen den beiden Versorgungsleiterpaaren getrennt ist.

Die Signalerkennungseinrichtung 20 der Einrichtung 1 umfasst einen mindestens in einer ersten Verbindungsleitung 9 des zweiten Verbindungsleitungspaares 3 angeordneten Ohmschen Widerstand 13 sowie einen mit seinem Emitter 14 mit der ersten Verbindungsleitung 9 auf einer ersten Seite 15 des Ohmschen Widerstandes 13 und mit seiner Basis 16 mit der ersten Verbindungsleitung 9 auf einer zweiten Seite 17 des Ohmschen Widerstandes 13 verbundenen Transistor 18. Der Transistor 18 ist dabei derart beidseitig des Ohmschen Widerstandes 13 mit der ersten Verbindungsleitung 9 verbunden, dass während eines Stromflusses durch einen an die beiden Verbindungsleiterpaare 2, 3 angeschlossenen zweikanaligen elektronischen Sensor 6 eine an dem ohmschen Widerstand 13 abfallende Spannung den Transistor 18 schaltet, so dass am Kollektor 19 des Transistors 18 bei angeschlossenem zweikanaligen Sensor 6 ein Ausgangssignal erzeugt wird, das zur Steuerung des Schalters 7 verwendet wird. Der Kollektor 19 ist hierzu mit der elektronischen Brücke zwischen Kanal 1 und Kanal 2 verbunden.

Wichtig ist hervorzuheben, dass die Erkennung eines durch einen Stromfluss gegebenen Signals eines mittels beider Verbindungsleitungspaare 2, 3 an die Sicherheitskombination angeschlossenen zweikanaligen elektronischen Sensors 6 wie folgt durchgeführt wird. In die die Eingangsleitung des zweiten Verbindungsleitungspaares 3 bildende Versorgungsleitung 9 ist ein kleiner Ohmscher Widerstand 13 eingefügt. Bei einem einkanaligen Not-Aus-Taster oder einem einkanaligen elektronischen Sensor 12 ist dieser Eingang unbeschaltet, so dass kein Stromfluss über diesen Widerstand 13 stattfindet. Bei Anschluss eines zweikanaligen Sensors 6 kommt es an diesem Eingang zu einem Stromfluss, der an dem Widerstand 13 einen Spannungsabfall zur Folge hat. Dieser Spannungsabfall wird dazu verwendet, einen Transistor 18 anzusteuern. Dieser Transistor 18 steuert ein internes Speicherglied, welches die interne Verbindung zwischen den beiden Verbindungsleiterpaaren 2, 3 unterbricht. Würde diese Verbindung nicht unterbrochen, so würde der zweikanalige elektronische Sensor 6 einen Querschluss erkennen und abschalten.

Die Erkennung, ob ein zweikanaliger elektronischer Sensor 6 angeschlossen ist, ist dabei im Eingang der Sicherheitskombination 5 verwirklicht, da elektronische Sensoren extern mit Spannung versorgt werden und deshalb außer dem durch den elektronischen Sensor initiierte Stromfluss keine weiteren Signale zur Verfügung stehen, die verwendet werden können. Darüber hinaus ist ein wesentlicher Gedanke der Erfindung, dass die Erkennung des Anschlusses eines zweikanaligen Sensors 6 für den Sensor selbst unsichtbar sein muss, damit die Querschlusserkennung des Sensors bis zu den Anschlussklemmen 21 der Sicherheitskombination 5 erhalten bleibt. Hierdurch scheiden Halbleiter zur Entkopplung aus. Würde beispielsweise zur Entkopplung eine Diode verwendet werden und würde hinter der Diode ein Querschluss auftreten, so könnte der elektronische Sensor 6 diesen Querschluss nicht erkennen. Darüber hinaus muss die interne Schutzfunktion der Sicherheitskombination 5, die einen Betrieb eines zweikanaligen Not-Aus-Tasters ohne Querschlusserkennung verhindert, erhalten bleiben.

## Patentansprüche

1. Einrichtung (1) zur automatischen Erkennung und Unterscheidung von ein- oder zweikanaligen elektronischen Sensoren (12, 6), welche an eine zweikanalige Sicherheitskombination (5) mit zwei Verbindungsleitungspaaren (2, 3) für Not-Aus-Einrichtungen (4) in Form von elektronischen Sensoren (6, 12) oder Not-Aus-Tastern (22) angeschlossen sind, wobei ein erstes Verbindungsleiterpaar (2) für einen einkanaligen Betrieb, und das erste (2) und ein zweites Verbindungsleitungspaar (3) für einen zweikanaligen Betrieb der Sicherheitskombination (5) vorgesehen sind, **gekennzeichnet durch** einen in mindestens einer ersten Verbindungsleitung (9) des zweiten Verbindungsleitungspaares (3) angeordneten Ohmschen Widerstand (13) sowie einen mit seinem Emitter (14) oder mit seinem Kollektor (19) mit einer ersten Seite (15) des Ohmschen Widerstandes (13) und mit seiner Basis (16) mit einer zweiten Seite (17) des Ohmschen Widerstandes (13) derart verbundenen Transistor (18), dass während eines Stromflusses **durch** einen an die beiden Verbindungsleiterpaare (2, 3) angeschlossenen zweikanaligen elektronischen Sensor (6) eine an dem ohmschen Widerstand (13) abfallende Spannung den Transistor (18) schaltet, so dass am Kollektor (19) oder am Emitter (14) des Transistors (18) ein Ausgangssignal erzeugt wird, welches einen Anschluss des zweikanaligen elektronischen Sensors (6) anzeigt.

2. Einrichtung nach Anspruch 1, **dadurch gekennzeichnet, dass** die Einrichtung (1) einen erste (8, 9) und/oder zweite Verbindungsleitungen (10, 11) der beiden Verbindungsleiterpaare (2, 3) elektrisch miteinander verbindenden oder trennenden, mittels des Ausgangssignals derart schaltbaren Schalter (7) umfasst, dass bei einem angeschlossenen, zweikanaligen elektronischen Sensor (12) eine ansonsten bestehende elektrische Verbindung zwischen den beiden Verbindungsleitungspaaren (2, 3) getrennt ist.

3. Einrichtung nach Anspruch 2, **dadurch gekennzeichnet, dass** der Schalter (7) in der Sicherheitskombination (5) angeordnet ist.

4. Einrichtung nach Anspruch 2 oder 3, **dadurch gekennzeichnet, dass** die Sicherheitskombination (5) zwei umschaltbare Betriebsmodi aufweist, einen Einkanal-Betriebsmodus zum Anschluss eines einkanaligen Not-Aus-Tasters (22) oder eines ein- (12) oder zweikanaligen elektronischen Sensors (6), sowie einen Zweikanal-Betriebsmodus zum parallelen Anschluss eines zweikanaligen Not-Aus-Tasters.

5. Einrichtung nach Anspruch 4, **dadurch gekennzeichnet, dass** der Schalter (7) zusätzlich mittels eines zweiten, von der Sicherheitskombination (5) in einem einkanaligen Betriebsmodus ausgegebenen Schaltsignals für den Fall des Anschlusses eines zweikanaligen Not-Aus-Tasters schaltbar ist.

6. Verfahren zur automatischen Erkennung und Unterscheidung von ein- (12) oder zweikanaligen (6) elektronischen Sensoren, welche an eine zweikanalige Sicherheitskombination (5) mit zwei Verbindungsleitungspaaren (2, 3) zum Anschluss von Not-Aus-Einrichtungen (4) in Form von elektronischen Sensoren (6, 12) oder Not-Aus-Tastern (22) angeschlossen sind, wobei ein erstes Verbindungsleiterpaar (2) für einen einkanaligen Betrieb, und das erste (2) und ein zweites Verbindungsleitungspaar (3) für einen zweikanaligen Betrieb der Sicherheitskombination (5) vorgesehen sind, **dadurch gekennzeichnet, dass** entlang mindestens einer Verbindungsleitung (9, 11) des zweiten Verbindungsleitungspaares (3) während eines Stromflusses durch einen an die beiden Verbindungsleiterpaare (2, 3) angeschlossenen zweikanaligen elektronischen Sensor ein elektrischer Spannungsabfall gemessen wird, dessen Polarität eine Anzeige für einen angeschlossenen zweikanaligen elektronischen Sensor (6) ist.

7. Verfahren nach Anspruch 6, **dadurch gekennzeichnet, dass** der Spannungsabfall verwendet wird, um eine ansonsten bestehende elektrische Verbindung zwischen den beiden Verbindungsleitungspaaren (2, 3) bei angeschlossenem zweikanaligen elektronischem Sensor (6) zu trennen.

## Claims

1. Facility (1) for the automatic recognition and differentiation of single-channel or dual-channel electronic sensors (12, 6), which are connected to a dual-channel safety combination (5) with two connecting line pairs (2, 3) for emergency stop facilities (4) in the form of electronic sensors (6, 12) or emergency stop buttons (22), with a first connecting conductor pair (2) being provided for single-channel operation and the first (2) and a second connecting line pair (3) being provided for dual-channel operation of the safety combination (5), **characterised by** an ohmic resistance (13) arranged in at least a first connecting line (9) of the second connecting line pair (3) and a transistor (18) connected by its emitter (14) or collector (19) to a first side (15) of the ohmic resistance (13) and by its base (16) to a second side (17) of the ohmic resistance (13) in such a manner that during a current flow through a dual-channel electronic sensor (6) connected to both connecting conductor pairs (2, 3) a voltage drop at the ohmic resistance (13) switches the transistor (18) so that an output signal is generated at the collector (19) or emitter (14) of the transistor (18), indicating connection of the dual-channel electronic sensor (6).

2. Facility according to claim 1, **characterised in that** the facility (1) comprises a switch (7) connecting or separating a first (8, 9) and/or second connecting line(s) (10, 11) of the two connecting conductor pairs (2, 3) electrically, said switch (7) being able to be switched by means of the output signal in such a manner that when a dual-channel electronic sensor (12) is connected, an otherwise existing electrical connection between both connecting line pairs (2, 3) is separated.

3. Facility according to claim 2, **characterised in that** the switch (7) is arranged in the safety combination (5).

4. Facility according to claim 2 or 3, **characterised in that** the safety combination (5) has two switchable operating modes, a single-channel operating mode for the connection of a single-channel emergency stop button (22) or a single-channel (12) or dual-channel electronic sensor (6), and a dual-channel operating mode for the parallel connection of a dual-channel emergency stop button.

5. Facility according to claim 4, **characterised in that** the switch (7) can also be switched by means of a second switching signal output by the safety combination (5) in single-channel operating mode when a dual-channel emergency stop button is connected.

6. Method for the automatic recognition and differentiation of single-channel (12) or dual-channel (6) electronic sensors, which are connected to a dual-channel safety combination (5) with two connecting line pairs (2, 3) for the connection of emergency stop facilities (4) in the form of electronic sensors (6, 12) or emergency stop buttons (22), with a first connecting conductor pair (2) being provided for single-channel operation and the first (2) and a second connecting line pair (3) being provided for dual-channel operation of the safety combination (5), **characterised in that** during a current flow through a dual-channel electronic sensor connected to both connecting conductor pairs (2, 3) an electrical voltage drop is measured along at least one connecting line (9, 11) of the second connecting line pair (3), the polarity of said voltage drop being an indicator of a connected dual-channel electronic sensor (6).

7. Method according to claim 6, **characterised in that** the voltage drop is used to separate an otherwise existing electrical connection between the two connecting line pairs (2, 3) when a dual-channel electronic sensor (6) is connected.

## Revendications

1. Dispositif ( 1 ) de détection et de différentiation automatique de capteurs ( 12, 6 ) électriques à un canal ou à deux canaux, qui sont reliés à une combinaison ( 5 ) de sécurité à deux canaux par deux paires ( 2,3 ) de ligne de liaison pour des dispositifs ( 4 ) d'arrêt d'urgence sous la forme de capteurs ( 6, 12 ) électroniques ou de suppresseurs ( 22 ) d'urgence, une première paire ( 2 ) de lignes de liaison étant prévue pour un fonctionnement sur un seul canal et la première ( 2 ) et une deuxième paire ( 3 ) de lignes de liaison étant prévues pour un fonctionnement sur deux canaux de la combinaison ( 5 ) de sécurité, **caractérisé par** une résistance ( 13 ) ohmique montée dans au moins une première ligne ( 9) de liaison de la deuxième paire ( 3 ) de lignes de liaison, ainsi que par un transistor ( 18 ) relié par son émetteur ( 14 ) ou par son collecteur ( 19 ) à un premier côté ( 15 ) de la résistance ( 13 ) ohmique et par sa base ( 16 ) par un deuxième côté ( 17) de la résistance ( 13 ) ohmique de manière à ce que, pendant un passage du courant dans un capteur ( 6 ) électronique à deux canaux reliés aux deux paires ( 2, 3 ) de lignes de liaison , une tension chutant aux bornes de la résistance ( 13 ) ohmique rend le transistor ( 18 ) passant, de manière à produire au collecteur ( 19 ) ou à l'émetteur ( 14 ) du transistor ( 18 ) un signal de sortie, qui indique une connexion du capteur ( 6 ) électronique à deux canaux.

2. Dispositif suivant la revendication 1, **caractérisé en ce que** le dispositif ( 1 ) comprend un premier interrupteur ( 7 ) reliant ou séparant entre elles électriquement des premières ( 8, 9 ) et/ou des deuxièmes ( 10, 11 ) lignes de liaison des deux paires ( 2, 3 ) de lignes de liaison et pouvant être commuté au moyen du signal de sortie de manière à ce que, lorsque le capteur ( 2 ) électronique à deux canaux est connecté, une liaison électrique qui existe sinon entre les deux paires ( 2, 3 ) de lignes de liaison est coupée.

3. Dispositif suivant la revendication 2, **caractérisé en ce que** l'interrupteur ( 7 ) est disposé dans la combinaison ( 5 ) de sécurité.

4. Dispositif suivant la revendication 2 ou 3, **caractérisé en ce que** la combinaison ( 5 ) de sécurité a deux modes de fonctionnement commutables, un mode de fonctionnement sur un canal pour la connexion d'un suppresseur ( 22 ) d'urgence à un canal ou d'un capteur ( 6 ) électronique à un canal ( 12 ) ou à deux canaux, ainsi qu'un mode de fonctionnement à deux canaux pour le montage en parallèle d'un suppresseur d'urgence à deux canaux.

5. Dispositif suivant la revendication 4, **caractérisé en ce que** l'interrupteur ( 7 ) peut être commuté supplémentairement au moyen d'un deuxième signal de commutation émis par la combinaison ( 6 ) de sécurité dans un mode de fonctionnement à un canal, dans le cas de la connexion d'un suppresseur d'urgence à deux canaux.

6. Procédé de détection et de différentiation automatique de capteurs électroniques à un canal ( 12 ) ou à deux canaux ( 6 ) qui, pour la connexion de dispositif ( 4 ) d'arrêt d'urgence sous forme de capteurs ( 6, 12 ) électroniques ou de suppresseurs ( 22 ) d'urgence, sont raccordés à une combinaison ( 5 ) de sécurité à deux canaux, dans lequel une première paire ( 2 ) de ligne de liaison est prévue pour un fonctionnement sur un canal et la première ( 2 ) et une deuxième paire ( 3 ) de lignes de liaison est prévue pour un fonctionnement sur deux canaux de la combinaison ( 5 ) de sécurité, **caractérisé en ce que**, le long d'au moins une ligne ( 9, 11 ) de liaison de la deuxième paire ( 3 ) de lignes de liaison, on mesure, pendant un passage du courant dans un capteur électronique à deux canaux connectés aux deux paires ( 2, 3 ) de lignes de liaison, une chute de tension électrique, dont la polarité est une indication de la connexion d'un capteur ( 6 ) électronique à deux canaux.

7. Procédé suivant la revendication 6, **caractérisé en ce que** l'on utilise la chute de tension pour couper une liaison électrique, existante sinon, entre les deux paires ( 2, 3 ) de lignes de liaison lorsque le capteur ( 6 ) électronique à deux canaux est connecté.
